(19) Europäisches Patentamt
European Patent Office
Office européen des brevets

(11) **EP 2 149 996 B1**

(12) **EUROPÄISCHE PATENTSCHRIFT**

(45) Veröffentlichungstag und Bekanntmachung des Hinweises auf die Patenterteilung:
**26.01.2011  Patentblatt 2011/04**

(51) Int Cl.:
*H04B 17/00* (2006.01)    *G01R 31/28* (2006.01)

(21) Anmeldenummer: **08018961.6**

(22) Anmeldetag: **30.10.2008**

(54) **Verfahren und Vorrichtung zur Herstellung einer quantisierbaren Phasenkohärenz zwischen zwei Hochfrequenzsignalen**

Method and device to manufacture a quantifiable phase coherence between two high frequency signals

Procédé et dispositif destinés à la fabrication d'une cohérence de phase quantifiable entre deux signaux haute fréquence

(84) Benannte Vertragsstaaten:
**DE**

(30) Priorität: **31.07.2008  EP 08013745**

(43) Veröffentlichungstag der Anmeldung:
**03.02.2010  Patentblatt 2010/05**

(73) Patentinhaber: **Rohde & Schwarz GmbH & Co. KG
81671 München (DE)**

(72) Erfinder: **Braunstorfinger, Thomas
80796 München (DE)**

(74) Vertreter: **Körfer, Thomas et al
Mitscherlich & Partner
Patent- und Rechtsanwälte
Sonnenstrasse 33
80331 München (DE)**

(56) Entgegenhaltungen:
**EP-A- 1 972 950        WO-A-03/093841
DE-A1-102006 057 316**

Anmerkung: Innerhalb von neun Monaten nach Bekanntmachung des Hinweises auf die Erteilung des europäischen Patents im Europäischen Patentblatt kann jedermann nach Maßgabe der Ausführungsordnung beim Europäischen Patentamt gegen dieses Patent Einspruch einlegen. Der Einspruch gilt erst als eingelegt, wenn die Einspruchsgebühr entrichtet worden ist. (Art. 99(1) Europäisches Patentübereinkommen).

## Beschreibung

Die Erfindung betrifft ein Verfahren und eine Vorrichtung zur Herstellung bzw. Wiederherstellung einer quantisierbaren Phasenkohärenz zwischen zwei Hochfrequenzsignalen.

Die Mehrantennenübertragung - Multiple-In-Multiple-Out (MIMO)-Übertragung - gewinnt zukünftig immer mehr an Bedeutung. Entsprechende MIMO-Empfänger mit mehreren Empfangsantennen existieren bereits. Das Testen derartiger MIMO-Empfänger erfordert die Erzeugung mehrerer zueinander phasenkohärenter Hochfrequenzsignale. Phasenkohärenz fordert im strengen Sinne eine fixe Phasendifferenz $\Delta\varphi$ zwischen zwei Hochfrequenz-Trägersignalen, die die gleiche Frequenz aufweisen oder sich in Vielfachen einer Frequenz unterscheiden, während Phasensynchronität als Spezialfall einer Phasenkohärenz einen gleichen Phasenwinkel für die beiden Hochfrequenzsignale voraussetzt.

Die Erzeugung von zwei oder mehreren zueinander phasenkohärenten Hochfrequenzsignalen in einem Signalgenerator ist in der Praxis nicht unproblematisch, da innerhalb eines Signalgenerator mehrere Störquellen für eine Phasenverschiebung der generierten Signale existieren, die zu einer unerwünschten Phaseninkohärenz zwischen zwei oder mehreren Hochfrequenzsignalen an den jeweiligen HF-Ausgängen des Signalgenerators führt.

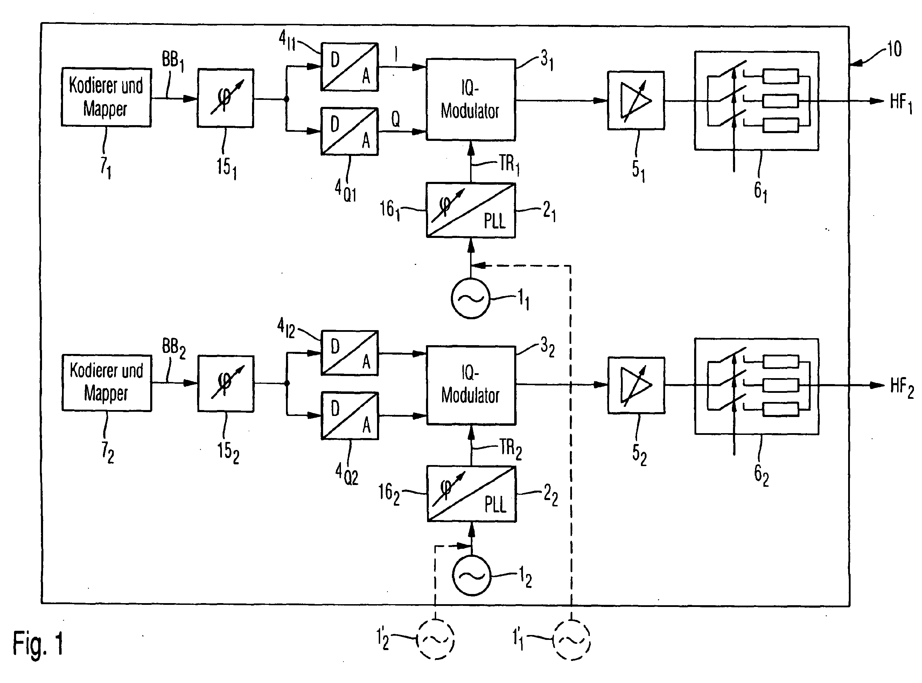

Hierzu sei auf die DE 101 30 687 A1 verwiesen, welche die Synchronisierung eines Signalgenerators mit einem Signalanalysator über ein Referenzsignal zeigt. Das Dokument WO-4-03093841 offenbart ein Verfahrens zum messen von Intermodulators verzenungen. Zu den wichtigsten Ursachen von Phasenverschiebungen in den einzelnen Signalpfaden eines in Fig. 1 dargestellten Signalgenerators 10 zählen:

- Phasenrauschen in den beiden Frequenzsynthesizern $2_1$ bzw. $2_2$, die jeweils von einem internen oder externen Oszillator $1_1$, $1_1'$ bzw. $1_2$, $1_2'$ gespeist werden, bei voneinander entkoppelter Erzeugung zweier Trägersignale für die beiden HF-Signale $HF_1$ bzw. $HF_2$,

- Phasendrift eines oder beider Frequenzsynthesizer $2_1$ bzw. $2_2$ aufgrund beispielsweise eines Offset-Fehlers im jeweiligen Phasendetektor,

- unterschiedliche elektrische Längen $\Delta x$ der zu den beiden HF-Signalen $HF_1$ bzw. $HF_2$ jeweils gehörigen Signalpfade und damit unterschiedliche Phasen der beiden HF-Signale $HF_1$ bzw. $HF_2$ aufgrund temperaturbedingter unterschiedlicher Ausdehnungen der beiden Signalpfade, wobei der Phasenunterschied zwischen den beiden HF-Signalen $HF_1$ bzw. $HF_2$ durch eine überlagerte Änderung der Frequenz der beiden HF-Signale gemäß Gleichung (1) zusätzlich verstärkt wird,

- Phasendrift zwischen den von den beiden Kodierern/Mappern $7_1$ bzw. $7_2$ erzeugten Basisbandsignalen $BB_1$ bzw. $BB_2$ und damit zwischen den beiden HF-Signalen $HF_1$ bzw. $HF_2$ aufgrund jeweils unterschiedlicher Verstärkungsfaktoren im Inphase- und Quadraturkanal der zugehörigen IQ-Modulatoren $3_1$ bzw. $3_2$,

- Phasendrift zwischen beiden Hochfrequenz-Signalen (HF-Signalen) **$HF_1$** bzw. $HF_2$ aufgrund von unterschiedlichen Gruppenlaufzeiten in den jeweiligen Analog-Digital-Wandlern $4_{I1}, 4_{Q1}$ bzw. $4_{I2}, 4_{Q2}$, IQ-Modulatoren $3_1$ bzw. $3_2$, Leistungsverstärkern $5_1$ bzw. $5_2$ und elektronisch schaltbaren Dämpfungsgliedern $6_1$ bzw. $6_2$ und

- Phasendrift zwischen den beiden HF-Signalen $HF_1$ bzw. $HF_2$ bei Änderung des Signalpegels der beiden HF-Signale $HF_1$ bzw. $HF_2$ aufgrund unterschiedlicher Amplituden-Phasen-Kennlinien der zum jeweiligen HF-Signal $HF_1$ bzw. $HF_2$ gehörigen Leistungsverstärker $5_1$ bzw. $5_2$ und elektronisch schaltbaren Dämpfungsglieder $6_1$ bzw. $6_2$:

$$\varphi = \frac{\Delta x}{\lambda} \bmod 2\pi = \frac{\Delta x \cdot f}{c} \bmod 2\pi \qquad (1)$$

Um eine quantisierbare Phasenkohärenz, die zwischen zwei in einem Signalgenerator erzeugten Hochfrequenz-Signalen auftritt, wiederherzustellen, muss in einem ersten Schritt eine Phasendifferenz ermittelt werden. Es sind mehrere verschiedene Verfahren zur Messung einer Phasendifferenz zwischen zwei Hochfrequenzsignalen bekannt.

Am einfachsten ist es, die beiden Hochfrequenzsignale jeweils an einen Eingang eines Oszilloskops zu führen und die beiden Hochfrequenzsignale gleichzeitig am Display des Oszilloskops über der Zeit darzustellen. Aus der eingestellten Zeitauflösung des Oszilloskops und dem am Display ablesbaren Abstands der Nulldurchgänge der beiden Hochfrequenzsignale kann sehr einfach die Phasendifferenz ermittelt werden. Aufgrund der schlechten Zeit- bzw. Phasenauflösung herkömmlicher Oszilloskope ist zur Phasendifferenzmessung eines 5 GHz HF-Signals ein vergleichsweise teueres Oszilloskop mit einer Bandbreite in der Höhe von 70 GHz erforderlich. Auch können mit einem Oszilloskop keine Signalpegel unterhalb von -30 dBm gemessen werden, so dass sie für die Messung in MIMO-Übertragungssystemen mit Signalpegeln in der Höhe von -100 dBm nicht geeignet sind.

Ein bekanntes Verfahren zur Messung einer Phasendifferenz zwischen zwei in einem Signalgenerator erzeugten Hochfrequenzsignalen liegt in der Verwendung eines Netzwerkanalysators. Hierzu ist der Signalgenerator des Netzwerkanalysators deaktiviert, während die beiden Hochfrequenzsignale an Port 1 und Port 2 des Netzwerkanalysators geführt werden. Über eine S21-Messung kann die Phasendifferenz zwischen dem am Port 1 angeschlossenen Hochfrequenzsignal und dem am Port 2 angeschlossenen Hochfrequenzsignal ermittelt werden. Als Messgerät zur Messung einer Phasendifferenz zwischen zwei Hochfrequenzsignalen ist ein Netzwerkanalysator relativ teuer und für Signalpegel unter -50 dBm nicht geeignet.

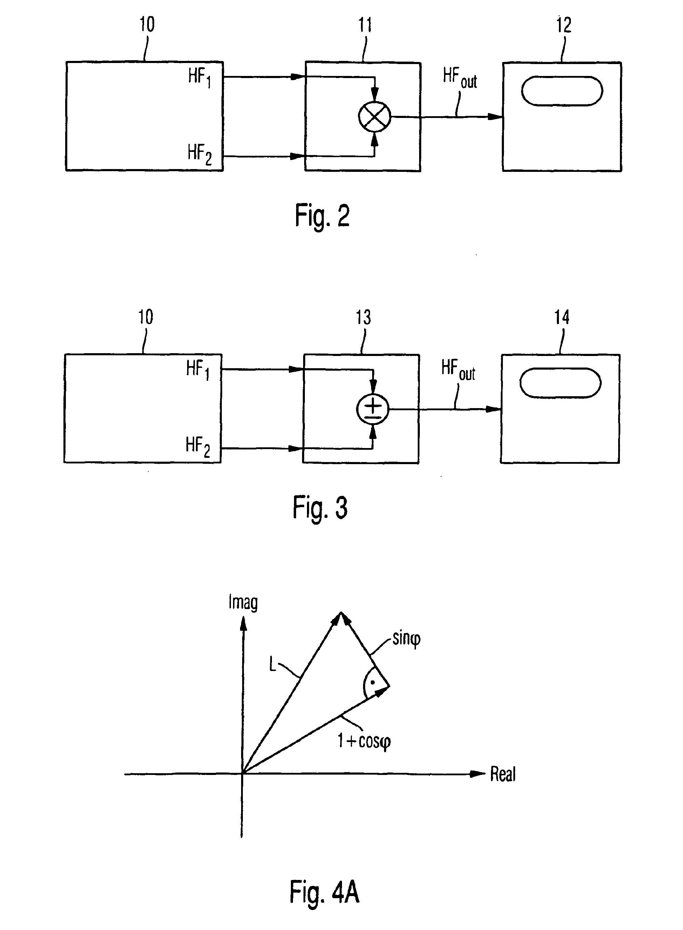

Schließlich wird die Phasendifferenz zwischen zwei Hochfrequenzsignalen $HF_1$ und $HF_2$, gemäß Fig. 2 mittels eines HF-Mischers 11 realisiert, an dessen HF-Signaleingänge die beiden Hochfrequenzsignale $HF_1$ und $HF_2$ geführt werden. Das Ausgangssignal $HF_{Out}$ des HF-Mixers 11 ergibt sich gemäß Gleichung (2).

$$HF_{Out} = HF_1 \cdot HF_2 = A\sin(\omega \cdot t)\, B\sin(\omega \cdot t + \varphi) =$$

$$= \frac{A \cdot B}{2}\left(\cos(\omega \cdot t - \omega \cdot t - \varphi) - \cos(\omega \cdot t + \omega \cdot t + \varphi)\right) =$$

$$= \frac{A \cdot B}{2}\left(\cos(-\varphi) - \cos(2 \cdot \omega \cdot t + \varphi)\right) \qquad\qquad (2)$$

Über ein Gleichspannungsvoltmeter 12 kann der Gleichanteil des Ausgangssignals des HF-Mischers 11 gemessen werden. Wird im Rahmen einer Kalibriermessung der maximale und der minimale Signalpegel des Ausgangssignal $HF_{Out}$ des HF-Mischers 11 gemessen, so können die unbekannten Größen $A$ und $B$ bestimmt werden und anschießend durch Anwendung der arccos-Funktion auf den gemessenen Gleichanteil des Ausgangssignals des HF-Mischers 11 die Phasendifferenz $\varphi$ zwischen den beiden Hochfrequenzsignalen $HF_1$ und $HF_2$ ermittelt werden.

Die Messung der Phasendifferenz zwischen den beiden Hochfrequenzsignalen mittels des HF-Mischers 11 und des Gleichspannungsvoltmeters 12 ist aber für Signalpegel unter +10 dBm nicht geeignet und ermöglicht aufgrund der Messung des Gleichanteils keine vorzeichenbehaftete Messung der Phasendifferenz zwischen zwei Hochfrequenz-Signalen, im Folgenden auch HF-Signale genannt.

Aufgabe der Erfindung ist es deshalb, ein Verfahren und

Vorrichtung zur Herstellung einer quantisierbaren Phasenkohärenz zwischen zwei in einem Signalgenerator erzeugten Hochfrequenzsignalen zu schaffen, das die erwähnten Nachteile herkömmlicher Verfahren und Vorrichtungen zur Phasendifferenzmessung zweier Hochfrequenz-Signale beseitigt und insbesondere für kleine Signalpegel bei der Messung in MIMO-Übertragungssystemen geeignet ist.

Die Erfindung wird durch ein Verfahren zur Herstellung einer quantisierbaren Phasenkohärenz zwischen zwei HF-Signalen mit den Merkmalen des Patentanspruchs 1 und durch eine Vorrichtung zur Herstellung einer quantisierbaren Phasenkohärenz zwischen zwei HF-Signalen mit den Merkmalen des Patentanspruchs 11 gelöst. Vorteilhafte technische Erweiterungen sind in den abhängigen Patentansprüchen aufgeführt.

Erfindungsgemäß werden die beiden Hochfrequenzsignale in einer Signalverknüpfungseinheit additiv verknüpft und die Amplitude des aus der additiven Verknüpfung entstandenen Messsignals mit einem Spektrumanalysator gemessen. Durch sukzessive Variation der Phase eines der beiden Hochfrequenzsignale - z. B. des ersten Hochfrequenzsignals - in Relation zur Phase des anderen Hochfrequenzsignals - z. B. des zweiten Hochfrequenzsignals - wird, wenn eine minimale Amplitude des Messsignals gemessen wird, bei Verwendung eines Summierers als Signalverknüpfungseinheit eine Phasendifferenz von 180° und damit eine quantisierbare Phasenkohärenz zwischen den beiden Hochfrequenzsignalen hergestellt. Bei theoretisch auch denkbarer Verwendung eines Subtrahierers als Signalverknüpfungseinheit wird durch sukzessives Variieren der Phase des ersten Hochfrequenzsignals in Relation zur Phase des zweiten Hochfrequenzsignals eine Phasedifferenz von 0° und damit eine Phasensynchronität - als Spezialfall einer quantisierbaren Phasenkohärenz - zwischen den beiden Hochfrequenzsignalen hergestellt, falls eine minimale Amplitude des Messsignals gemessen wird.

Falls die Amplituden der beiden Hochfrequenzsignale unterschiedlich ist, wird im Wechsel zur sukzessiven Variation der Phase des einen der beiden Hochfrequenzsignals in Relation zur Phase des anderen Hochfrequenzsignals die Amplitude des einen der beiden Hochfrequenzsignals in Relation zur Amplitude des anderen Hochfrequenzsignals sukzessive variiert, bis wiederum die Amplitude des Messsignals minimal wird.

Um ein zeitaufwendiges iteratives Suchen der minimalen Amplitude des Messsignals zu vermeiden, wird in einem ersten Schritt nur eine Näherung des Amplitudenminimums des Messsignals - ein grober Wert des Amplitudenminimums des Messsignals - und damit eine Näherung für die Phase ermittelt. Ausgehend von der zu dieser Näherung des Amplitudenminimums des Messsignals gehörigen Näherung der Phasendifferenz zwischen den beiden Hochfrequenzsignalen wird die Phase eines der beiden Hochfrequenzsignale in Relation zur Phase des anderen Hochfrequenzsignals soweit reduziert, bis sich eine erste Phase einstellt, bei der ein bestimmter vorher festgelegter Amplitudenwert des Messsignals erreicht ist. Daraufhin wird ausgehend von der zur ermittelten Näherung des Amplitudenminimums des Messsignals gehörigen Näherung der Phasendifferenz zwischen den beiden Hochfrequenzsignalen die Phase eines der beiden Hochfrequenzsignale in Relation zur Phase des anderen Hochfrequenzsignals soweit erhöht, bis sich eine zweite Phase einstellt, bei der wiederum der vorher festgelegte Amplitudenwert des Messsignals erreicht ist. Ein exakter Wert für die Phase, bei der die Amplitude des Messsignals ein exaktes Minimum aufweist, ergibt sich aus dem Mittelwert der ersten und zweiten Phase.

Die Variation der Phase des ersten Hochfrequenzsignals in Relation zur Phase des zweiten Hochfrequenzsignals erfolgt innerhalb des die beiden Hochfrequenzsignale erzeugenden Signalgenerators entweder durch manuelles oder automatisiertes Verstellen der Phase des zum ersten Hochfrequenzsignal gehörigen ersten Basisbandsignals in Relation zur Phase des zum zweiten Hochfrequenzsignal gehörigen zweiten Basisbandsignals oder der Phase des zum ersten Hochfrequenzsignal gehörigen ersten Trägersignals in Relation zur Phase des zum zweiten Hochfrequenzsignal gehörigen zweiten Trägersignals.

Die Variation der Amplitude des ersten Hochfrequenzsignals in Relation zur Amplitude des zweiten Hochfrequenzsignals erfolgt innerhalb des die beiden Hochfrequenzsignale erzeugenden Signalgenerators durch manuelles oder automatisiertes Verstellen des bzw. der Verstärkungsfaktors(en) des bzw. der im Signalpfad des ersten Hochfrequenzsignals befindlichen Verstärkereinheit(en) in Relation des bzw. der Verstärkungsfaktors(en) des bzw. der im Signalpfad des zweiten Hochfrequenzsignals befindlichen Verstärkereinheit(en).

Das automatisierte Verstellen der Phase des ersten bzw. zweiten Basisbandsignals oder des ersten bzw. zweiten Trägersignals erfolgt bei einer zeitinvarianten Phasendifferenz einmalig und bei einer zeitvarianten Phasendifferenz zeitkontinuierlich in einem bestimmten Zeitraster innerhalb eines bestimmten Zeitintervalls. Falls die beiden Hochfrequenzsignale entweder dieselbe Frequenz aufweisen oder sich in einem ganzzahligen Verhältnis zwischen ihren Frequenzen unterscheiden, die Frequenz aber über der Zeit variiert wird, so kann die Phase des ersten bzw. zweiten Basisbandsignals oder des ersten bzw. zweiten Trägersignals auch in einem bestimmten Frequenzraster innerhalb eines bestimmten Frequenzspektrums - Sweepbetrieb - zur Kompensation von frequenzabhängigen Phasendifferenzen verstellt werden. Hierbei kann die Verstellung der Phase auch entweder einmalig zu einem bestimmten Zeitpunkt oder zeitkontinuierlich in einem bestimmten Zeitraster innerhalb eines bestimmten Zeitintervalls - "dreidimensionale Phasenverstellung" - erfolgen.

Die beiden Hochfrequenzsignale stellen jeweils (Pseudo)-Continous-Wave-Signale (Pseudo-CW-Signale) dar und weisen folglich jeweils eine konstante Amplitude und eine konstante Frequenz auf und sind mit DC-Basisbandsignalen moduliert.

Falls den Amplituden der beiden Hochfrequenzsignale und damit der Amplitude des Messsignals ein störender Rauschsignalanteil überlagert ist, wird dieser Rauschsignalanteil durch Mitteln über mehrere aufeinander folgende Amplitudenwerte des Messsignals beseitigt.

Eine durch unterschiedliche Verstärkungsfaktoren im Inphase- und Quadraturkanal des IQ-Modultors hervorgerufene Phasendrift eines Basisbandsignals in Relation zur Phase des anderen Basisbandsignals wird durch bewusstes zeitliches Wechseln der verwendeten Symbole der beiden Basisbandsignale ausgeglichen.

Die Signalverknüpfungseinheit zur additiven Verknüpfung der beiden Hochfrequenzsignale ist entweder als Addierer oder als Subtrahierer realisiert. Im Fall eines Addierers wird bevorzugt ein in umgekehrter Signalpfadrichtung geschalteter ohmscher Leistungsteiler verwendet.

Das erfindungsgemäße Verfahren und die erfindungsgemäße Vorrichtung zur Wiederherstellung einer quantisierbaren Phasenkohärenz zwischen zwei Hochfrequenzsignalen werden im Folgenden anhand der Zeichnung erläutert. Die Figuren der Zeichnung zeigen:

Fig. 1    ein Blockdiagramm zweier in üblicher Weise synchronisierter Signalgeneratoren,

Fig. 2    ein Blockdiagramm einer üblichen Vorrichtung zur Phasendifferenzmessung mit einem HF-Mischer und einem DC-Voltmeter,

Fig. 3    ein Blockdiagramm einer erfindungsgemäßen Vorrichtung zur Wiederherstellung einer quantisierbaren Phasenkohärenz zwischen zwei Hochfrequenzsignalen,

Fig. 4A    ein Zustandsdiagramm mit dem Messsignal, das in einer ersten Ausführungsform der erfindungsgemäßen Vorrichtung zur Wiederherstellung einer quantisierbaren Phasenkohärenz zwischen zwei Hochfrequenzsignalen erzeugt wird,

Fig. 4B        ein Zustandsdiagramm mit dem Messsignal, das in einer zweiten Ausführungsform der erfindungsgemäßen Vorrichtung zur Wiederherstellung einer quantisierbaren Phasenkohärenz zwischen zwei Hochfrequenzsignalen erzeugt wird,

Fig. 5         eine Schaltungsanordnung einer additiven Signalverknüpfungseinheit,

Fig. 6A        ein Amplitude-Phasen-Diagramm zur ersten Ausführungsform der erfindungsgemäßen Wiederherstellung einer quantisierbaren Phasenkohärenz zwischen zwei Hochfrequenzsignalen,

Fig. 6B        ein Amplitude-Phasen-Diagramm zur zweiten Ausführungsform der erfindungsgemäßen Wiederherstellung einer quantisierbaren Phasenkohärenz zwischen zwei Hochfrequenzsignalen,

Fig. 7         ein Amplituden-Amplitudendifferenz-Diagramm zur erfindungsgemäßen Wiederherstellung einer quantisierbaren Phasenkohärenz zwischen zwei Hochfrequenzsignalen,

Fig. 8A        ein Flussdiagramm eines Beispiels zur Wiederherstellung einer quantisierbaren Phasenkohärenz zwischen zwei Hochfrequenzsignalen und

Fig. 8B        ein Flussdiagramm einer Ausführungsform eines erfindungsgemäßen Verfahrens zur Wiederherstellung einer quantisierbaren Phasenkohärenz zwischen zwei Hochfrequenzsignalen.

Erfindungsgemäß werden, wie in Fig. 3 dargestellt ist, die beiden Hochfrequenzsignale - erstes und zweites Hochfrequenzsignal $HF_1$ und $HF_2$ - vom Signalgenerator 10 jeweils an einen der beiden Eingänge einer Signalverknüpfungseinheit 13 geführt, die die beiden Hochfrequenzsignale $HF_1$ und $HF_2$ zu einem Messsignal $HF_{Out}$ additiv verknüpft. Bei der Signalverknüpfungseinheit 13 kann es sich, wie aus Fig. 3 hervorgeht, entweder um einen Addierer, der die beiden Hochfrequenzsignale $HF_1$ und $HF_2$ summiert, oder theoretisch auch um einen Subtrahierer handeln, der die beiden Hochfrequenzsignale $HF_1$ und $HF_2$ voneinander subtrahiert.

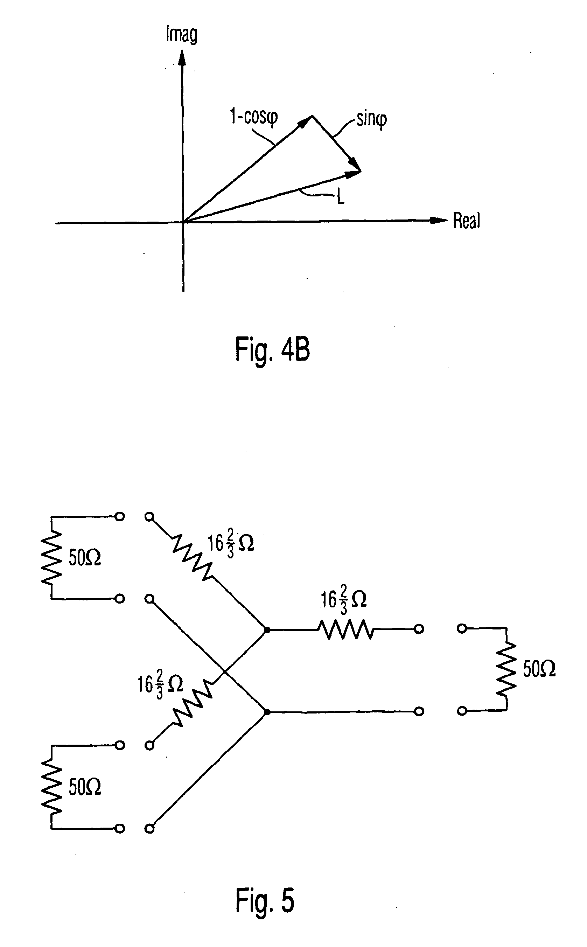

Im Fall einer als Addierer geschalteten Signalverknüpfungseinheit 13 wird ein symmetrisch aufgebauter ohmscher Leistungsteiler eingesetzt, der gemäß Fig. 5 in einer zur bei Leistungsteilern üblichen Signalflussrichtung umgekehrten Signalflussrichtung geschaltet ist. Neben seiner hohen Symmetrie hat der Leistungsteiler eine hohe Temperaturstabilität. Aufgrund seiner ohmschen Übertragungscharakteristik kommt es im Leistungsteiler und damit im Addierer zu keiner zusätzlichen Phasenverschiebung. Die Phase des Messsignals $HF_{Out}$ am Ausgang der Signalverknüpfungseinheit 13 folgt den Phasen der beiden Hochfrequenzsignale $HF_1$ und $HF_2$ am Eingang der Signalverknüpfungseinheit 13.

Die Amplitude des Messsignals $HF_{Out}$ wird von einem Spektrumanalysator 14 gemessen. Sämtlich in der erfindungsgemäßen Vorrichtung zur Wiederherstellung einer quantisierbaren Phasenkohärenz zwischen zwei Hochfrequenzsignalen verwendeten Stecker weisen äquivalent zur Signalverknüpfungseinheit 13 ein optimiertes Phasenübertragungsverhalten - minimierte Phasenverschiebungen - auf.

Das Ausgangssignal $HF_{Out}$ der ersten Ausführungsform der Signalverknüpfungseinheit 13 - Addierer - ergibt sich gemäß Gleichung (3), wobei die Amplitude A des ersten HF-Signals $HF_1$ und die Amplitude B des zweiten HF-Signals $HF_2$ im ersten Schritt identisch zu L angenommen wird.

$$HF_{Out} = HF_1 + HF_2 = A\sin(\omega \cdot t) + B\sin(\omega \cdot t + \varphi) =$$
$$= L \cdot (\sin(\omega \cdot t) + \sin(\omega \cdot t + \varphi)) =$$
$$= L \cdot (sin(\omega \cdot t) + sin(\omega \cdot t)\cos(\varphi) + \cos(\omega \cdot t)\sin(\varphi)) =$$
$$= L(\sin(\omega \cdot t) \cdot (1 + \cos(\varphi)) + \cos(\omega \cdot t) \cdot \sin(\varphi)) \qquad (3)$$

Das Messsignal $HF_{Out}$ gemäß Gleichung (3) ergibt sich gemäß Fig. 4A als ein mit der Kreisfrequenz ω rotierender Vektor in der komplexen Ebene, der sich aus zwei zueinander orthogonalen Vektoren - $L \cdot \sin(\omega \cdot t) \cdot (1+\cos(\varphi))$ und $L \cdot \cos(\omega \cdot t) \cdot \sin(\varphi)$ - zusammensetzt, die ebenfalls mit der Kreisfrequenz ω rotieren.

Die Amplituden dieser beiden zueinander orthogonalen Vektoren betragen jeweils $L \cdot (1+\cos(\varphi))$ und $L \cdot \sin(\varphi)$. Die Amplitude $gs1_{Out}$ des Messsignal $HF_{Out}$ ergibt sich folglich gemäß Gleichung (4).

$$\widehat{HF_{Out}} = \dot{L} \cdot \sqrt{(1+\cos(\varphi))^2 + \sin(\varphi)^2} = L \cdot \sqrt{2 + 2\cos(\varphi)} \qquad (4)$$

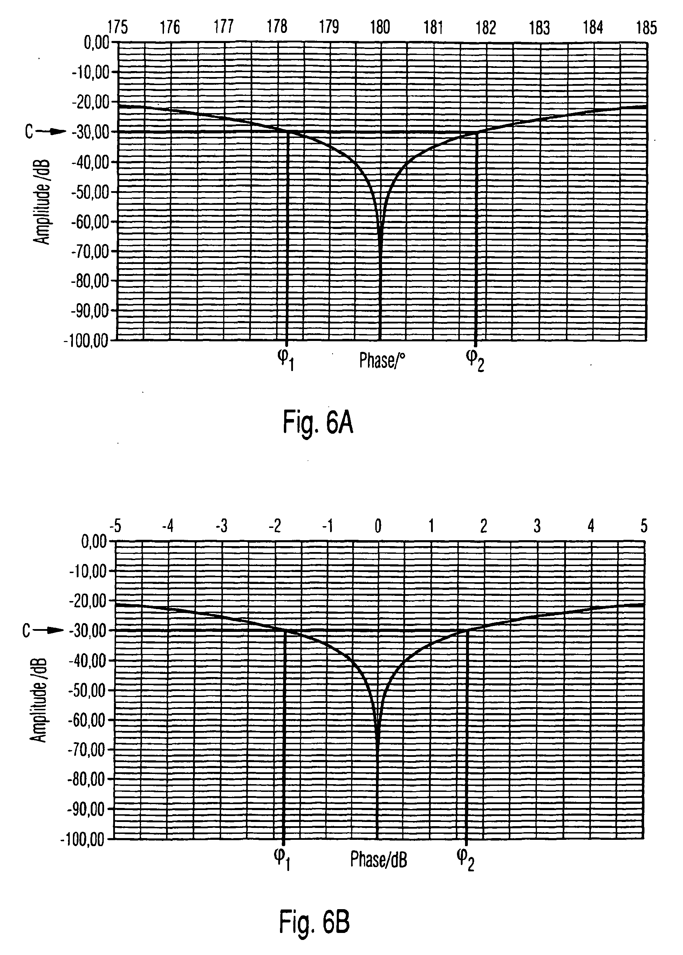

Beträgt folglich die Phasendifferenz φ zwischen den beiden Hochfrequenzsignalen $HF_1$ und $HF_2$ 0°, so ergibt sich für die Amplitude $\widehat{HF}_{Out}$ des Messsignals $HF_{Out}$ ein maximaler Wert von 2·L· Ist die Phasendifferenz φ zwischen den beiden Hochfrequenzsignalen $HF_1$ und $HF_2$ dagegen 180°, so ergibt sich für die Amplitude $\widehat{HF}_{Out}$ des Messsignals $HF_{Out}$ ein minimaler Wert von Null. In Fig. 6A ist der Zusammenhang der Amplitude $\widehat{HF}_{Out}$ des Messsignals $HF_{Out}$ als Funktion der Phasendifferenz φ zwischen den beiden Hochfrequenzsignalen $HF_1$ und $HF_2$ bei einer als Summierer geschalteten Signalverknüpfungseinheit 13 dargestellt.

Wird durch bestimmte Maßnahmen, die weiter unten noch im Detail ausgeführt werden, die Phase eines der beiden Hochfrequenzsignale in Relation zur Phase des anderen Hochfrequenzsignals soweit variiert, dass die Amplitude des Messsignals $HF_{Out}$ ihr Minimum auf Dauer erreicht, so weisen die beiden Hochfrequenzsignale $HF_1$ und $HF_2$ gemäß Fig. 6A eine Phasendifferenz φ von 180° auf und es liegt aufgrund der Eindeutigkeit des Minimums eine quantisierbare Phasenkohärenz in Höhe von 180° zwischen den beiden Hochfrequenzsignalen $HF_1$ und $HF_2$ vor.

Wird in der zweiten Ausführungsform der Signalverknüpfungseinheit 13 dagegen ein Subtrahierer verwendet, so ergibt sich für das Ausgangssignal $HF_{Out}$ die Beziehung gemäß Gleichung (5), wobei auch hier im ersten Schritt die Amplitude A des ersten HF-Signals $HF_1$ und die Amplitude B des zweiten HF-Signals $HF_2$ identisch zu L angenommen wird.

$$\begin{aligned} HF_{Out} &= HF_1 + HF_2 = A\sin(\omega \cdot t) - B\sin(\omega \cdot t + \varphi) = \\ &= L \cdot (\sin(\omega \cdot t) - \sin(\omega \cdot t + \varphi)) = \\ &= L \cdot (sin(\omega \cdot t) - sin(\omega \cdot t)\cos(\varphi) - \cos(\omega \cdot t)\sin(\varphi)) = \\ &= L(\sin(\omega \cdot t) \cdot (1 - \cos(\varphi)) - \cos(\omega \cdot t) \cdot \sin(\varphi)) \qquad (5) \end{aligned}$$

Die Amplitude $\widehat{HF}_{Out}$ des Messsignal $HF_{Out}$ ergibt sich folglich gemäß Gleichung (6).

$$\widehat{HF_{Out}} = L \cdot \sqrt{(1-\cos(\varphi))^2 + \sin(\varphi)^2} = L \cdot \sqrt{2 - 2\cos(\varphi)} \qquad (6)$$

Das Messsignal $HF_{Out}$ gemäß Gleichung (5) ergibt sich gemäß Fig. 4B als ein mit der Kreisfrequenz ω rotierender Vektor in der komplexen Ebene, der sich aus zwei zueinander orthogonalen Vektoren - $L \cdot \sin(\omega \cdot t) \cdot (1-\cos(\varphi))$ und $-L \cdot \cos(\omega \cdot t) \cdot \sin(\varphi)$ - zusammensetzt, die ebenfalls mit der Kreisfrequenz ω rotieren.

Die Amplituden dieser beiden zueinander orthogonalen Vektoren betragen jeweils $L \cdot (1-\cos(\varphi))$ und $L \cdot \sin(\varphi)$. Beträgt folglich die Phasendifferenz φ zwischen den beiden Hochfrequenzsignalen $HF_1$ und $HF_2$ 0°, so ergibt sich für die Amplitude $\widehat{HF}_{Out}$ des Messsignals $HF_{Out}$ ein minimaler Ordinatenwert von Null. Ist die Phasendifferenz φ zwischen den beiden Hochfrequenzsignalen $HF_1$ und $HF_2$ dagegen 180°, so ergibt sich für die Amplitude $\widehat{HF}_{Out}$ des Messsignals $HF_{Out}$ ein maximaler Ordinatenwert von 2·L. In Fig. 6B ist der Zusammenhang der Amplitude $HF_{Out}$ des Messsignals $HF_{Out}$ als Funktion der Phasendifferenz φ zwischen den beiden Hochfrequenzsignalen $HF_1$ und $HF_2$ bei einer als Subtrahierer realisierten Signalverknüpfungseinheit 13 dargestellt.

Wird durch bestimmte Maßnahmen, die weiter unten noch im Detail ausgeführt werden, die Phase eines der beiden Hochfrequenzsignale in Relation zur Phase des anderen Hochfrequenzsignals soweit variiert, dass die Amplitude des Messsignals $HF_{Out}$ ihr Minimum auf Dauer erreicht, so weisen die beiden Hochfrequenzsignale $HF_1$ und $HF_2$ gemäß Fig. 6B eine Phasendifferenz φ von 0° auf Dauer auf und es liegt aufgrund der Eindeutigkeit des Minimums eine quantisierbare Phasensynchronität - als Spezialfall einer quantisierbaren Phasenkohärenz in Höhe von 0° - zwischen den

beiden Hochfrequenzsignalen $HF_1$ und $HF_2$ vor.

Ist die Amplitude $A$ des ersten HF-Signals $HF_1$ nicht identisch zur Amplitude $B$ des zweiten HF-Signals $HF_2$, so ergibt sich im Fall einer als Summierer realisierten Signalverknüpfungseinheit 13 ausgehend von Gleichung (4) eine Beziehung für die Amplitude $\widehat{HF}_{Out}$ des Messsignals $\widehat{HF}_{Out}$ gemäß Gleichung (7) und im Fall einer als Subtrahierer realisierten Signalverknüpfungseinheit 13 ausgehend von Gleichung (6) eine Beziehung für die Amplitude $\widehat{HF}_{Out}$ des Messsignals $HF_{Out}$ gemäß Gleichung (8).

$$\widehat{HF}_{Out} = \sqrt{(A + \cos B(\varphi))^2 + B\sin(\varphi)^2} = \sqrt{A^2 + B^2 + 2AB\cos(\varphi)} \qquad (7)$$

$$\widehat{HF}_{Out} = \sqrt{(A - B\cos(\varphi))^2 + B\sin(\varphi)^2} = \sqrt{A^2 + B^2 - 2AB\cos(\varphi)} \qquad (8)$$

Während im Fall einer als Summierer realisierten Signalverknüpfungseinheit 13 das Minimum der Amplitude $\widehat{HF}_{Out}$ des Messsignals $HF_{Out}$ äquivalent zum Fall bei identischen Amplituden der beiden Hochfrequenzsignale $HF_1$ und $HF_2$ bei einer Phasendifferenz $\varphi$ von 180° liegt und den Ordinatenwert $\sqrt{A^2 + B^2 + 2AB}$ aufweist, ist im Fall einer als Subtrahierer realisierten Signalverknüpfungseinheit 13 das Minimum der Amplitude $HF_{Out}$ des Messsignals $HF_{Out}$ äquivalent zum Fall bei identischen Amplituden der beiden Hochfrequenzsignale $HF_1$ und $HF_2$ bei einer Phasendifferenz $\varphi$ von 0° und weist den Ordinatenwert $\sqrt{A^2 + B^2 - 2AB}$ auf.

Die Bestimmung des Minimums der Amplitude $HF_{Out}$ des Messsignals $HF_{Out}$ bei den von Null verschiedenen Ordinatenwerten $\sqrt{A^2 + B^2 + 2AB}$ bzw. $\sqrt{A^2 + B^2 - 2AB}$ im Fall unterschiedlicher Amplituden A und B des ersten und zweiten Hochfrequenzsignals $HF_1$ und $HF_2$ ist für eine eindeutige und exakte Bestimmung einer quantisierbaren Phasenkohärenz zweier Hochfrequenzsignalen $HF_1$ und $HF_2$ nicht ausreichend, wie im Folgenden gezeigt wird:

Hierzu müssen die beiden Amplituden $A$ und $B$ des ersten und zweiten Hochfrequenzsignals $HF_1$ und $HF_2$, die üblicherweise im logarithmischen Maßstab angegeben werden, in einen linearen Maßstab überführt werden, um anschließend eine Amplitude Res des Restsignals aus der Differenz der im linearen Maßstab vorliegenden Amplituden $A$ und $B$ des ersten und zweiten Hochfrequenzsignals $HF_1$ und $HF_2$ im linearen Maßstab zu berechnen. Schließlich erfolgt daraufhin eine Logarithmierung der im linearen Maßstab vorliegenden Amplitude Res des Restsignals. Die im logarithmischen Maßstab vorliegende Amplitude Re$s$ des Restsignals aus der Differenz der im linearen Maßstab vorliegenden Amplituden $A$ und $B$ des ersten und zweiten Hochfrequenzsignals $HF_1$ und $HF_2$ ergibt sich folglich gemäß Gleichung (9).

$$\mathrm{Re}\,s = 20 \cdot log\left(\left|10^{A/20} - 10^{B/20}\right|\right) \qquad (9)$$

Unter der Annahme, dass der Mittelwert zwischen den beiden Amplituden $A$ und $B$ des ersten und zweiten Hochfrequenzsignals $HF_1$ und $HF_2$ der Größe $L$ entspricht und die beiden Amplituden $A$ und $B$ des ersten und zweiten Hochfrequenzsignals $HF_1$ und $HF_2$ jeweils einen Abstand $\frac{\Delta}{2}$ von dieser Größe L aufweisen, ergibt sich ausgehend von Gleichung (9) eine Beziehung für die Amplitude Res des Restsignals aus der Differenz der im linearen Maßstab vorliegenden Amplituden $A$ und $B$ des ersten und zweiten Hochfrequenzsignals $HF_1$ und $HF_2$ gemäß Gleichung (10).

$$\mathrm{Re}\,s = 20 \cdot log\left(\left|10^{(L+\frac{\Delta}{2})/20} - 10^{(L-\frac{\Delta}{2})/20}\right|\right) =$$

$$= 20 \cdot log\left(\left|10^{\frac{L}{20}} \cdot (10^{0,5\frac{\Delta}{20}} - 10^{-0,5\frac{\Delta}{20}})\right|\right) =$$

$$= L + 20 \cdot log\left(\left|10^{0,5\frac{\Delta}{20}} - 10^{-0,5\frac{\Delta}{20}}\right|\right) \qquad (10)$$

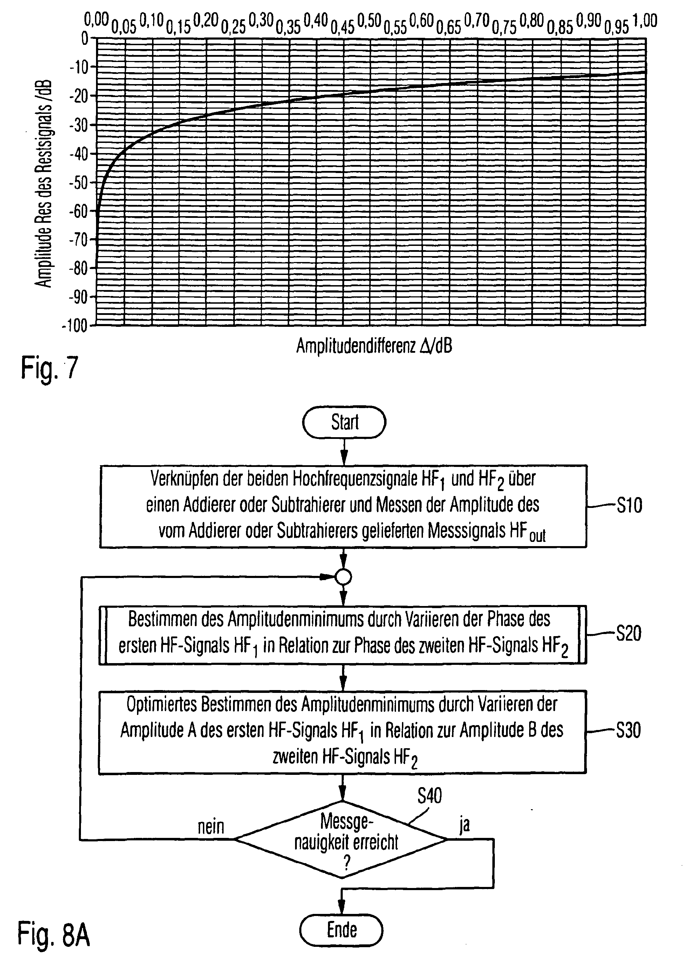

In Fig. 7 ist der Zusammenhang zwischen der Amplitude Res des Restsignals im logarithmischen Maßstab in Abhängigkeit der ebenfalls im logarithmischen Maßstab ermittelten Amplitudendifferenz $\Delta$ zwischen den Amplituden $A$ und $B$ des ersten und zweiten Hochfrequenzsignals $HF_1$ und $HF_2$ dargestellt.

Man erkennt aus Fig. 7, dass sich bei einer beispielhaften Amplitudendifferenz $\Delta$ zwischen den beiden Amplituden $A$ und $B$ des ersten und zweiten Hochfrequenzsignals $HF_1$ und $HF_2$ in Höhe von 0,2 dB eine Amplitude Re$s$ des Restsignals in Höhe von ca. -27 dB einstellt. Da sich dieser Amplitudenwert gemäß Fig. 6A bzw. 6B auch bei identischen Amplituden $A$ und $B$ des ersten und zweiten Hochfrequenzsignals $HF_1$ und $HF_2$ bei einer Phasendifferenz zwischen den beiden Hochfrequenzsignalen $HF_1$ und $HF_2$ in Höhe von 2,5° einstellt, wird mit einer reinen Bestimmung des Amplitudenminimums des Messsignals $HF_{Out}$ noch keine exakte quantisierbare Phasenkohärenz ermittelt. Sinnvoll ist es vielmehr im Hinblick auf eine Ermittlung einer exakt und eindeutig quantisierbaren Phasenkohärenz zwischen den beiden Hochfrequenzsignalen $HF_1$ und $HF_2$ eine eventuell vorliegende Amplitudendifferenz $\Delta$ zwischen den beiden Amplituden $A$ und $B$ des ersten und zweiten Hochfrequenzsignals $HF_1$ und $HF_2$ durch Variieren des Signalpegels $A$ des ersten Hochfrequenzsignals $HF_1$ in Relation zum Signalpegel B des zweiten Hochfrequenzsignals zu minimieren.

Das in Fig. 8A dargestellte Beispiel zur Wiederherstellung einer quantisierbaren Phasenkohärenz zwischen zwei Hochfrequenzsignalen beginnt in Verfahrensschritt S10 mit der signaltechnischen Verknüpfung der beidem vom Signalgenerator 10 erzeugten Hochfrequenzsignale $HF_1$ und $HF_2$ mit jeweils einem der beiden Eingänge der Signalverknüpfungseinheit 13. Das am Ausgang der Signalverknüpfungseinheit 13 erzeugte Messsignal $HF_{Out}$, das im Fall der Verwendung eines Summierers der Summe aus dem ersten und zweiten Hochfrequenzsignal $HF_1$ und $HF_2$ und im Fall der Verwendung eines Subtrahierers der Differenz des ersten und zweiten Hochfrequenzsignal $HF_1$ und $HF_2$ entspricht, wird dem Eingang eines Spektrumanalysators 14 zugeführt, der die Amplitude $gs\dot{1}_{Out}$ des Messsignals $HF_{Out}$ misst.

Im darauffolgenden Verfahrensschritt S20 wird in der ersten Ausführungsform des erfindungsgemäßen Verfahrens die Phase des ersten Hochfrequenzsignals $HF_1$ in Relation zur Phase des zweiten Hochfrequenzsignals $HF_2$ solange variiert, bis im Spektrumanalysator 14 für die Amplitude $gs\dot{1}_{Out}$ des Messsignals $HF_{Out}$ ein Minimum gemessen wird.

Die Variation der Phase des ersten Hochfrequenzsignals $HF_1$ in Relation zur Phase des zweiten Hochfrequenzsignals $HF_2$ kann entweder durch Verstellen der Phase des zum ersten Hochfrequenzsignals $HF_1$ gehörigen ersten Basisbandsignals $BB_1$ in Relation zur Phase des zum zweiten Hochfrequenzsignals $HF_2$ gehörigen zweiten Basisbandsignals $BB_2$ mittels des im Signalpfad des ersten Basisbandsignals $BB_1$ befindlichen Phasenschiebers $15_1$ bzw. des im Signalpfad des zweiten Basisbandsignals $BB_2$ befindlichen Phasenschiebers $15_2$ oder alternativ durch Verstellen der Phase des zum ersten Hochfrequenzsignals $HF_1$ gehörigen ersten Trägersignals $TR_1$ in Relation zur Phase des zum zweiten Hochfrequenzsignals $HF_2$ gehörigen zweiten Trägersignals $TR_2$ mittels des im Signalpfad des ersten Trägersignals $TR_1$ befindlichen Phasenschiebers $16_1$ bzw. des im Signalpfad des zweiten Trägersignals $TR_2$ befindlichen Phasenschiebers $16_2$ erfolgen.

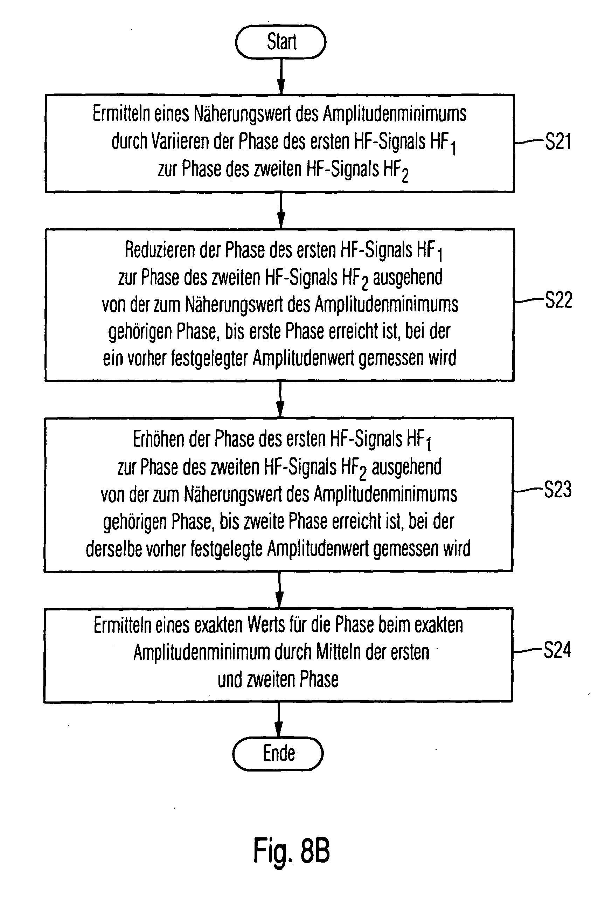

In der Ausführungsform des erfindungsgemäßen Verfahrens wird der Verfahrensschritt S20 durch die im Flussdiagramm der Fig. 8B dargestellten Verfahrensschritte S21 bis S24 ersetzt:

Im Verfahrensschritt S21 der Ausführungsform des erfindungsgemäßen Verfahrens wird analog zu Verfahrensschritt S20 in Fig. 6A durch Variation der Phase des ersten Hochfrequenzsignals $HF_1$ in Relation zur Phase des zweiten Hochfrequenzsignals $HF_2$ kein exakter Wert für das Minimum der Amplitude $gs\dot{1}_{Out}$ des Messsignals $HF_{Out}$ und damit für die zugehörige Phase des ersten Hochfrequenzsignals $HF_1$ in Relation zur Phase des zweiten Hochfrequenzsignals $HF_2$, sondern nur ein grober Näherungswert für das Minimum der Amplitude $gs\dot{1}_{Out}$ des Messsignals

$HF_{Out}$ und damit für die zugehörige Phase des ersten Hochfrequenzsignals $HF_1$ in Relation zur Phase des zweiten Hochfrequenzsignals $HF_2$ ermittelt.

Ausgehend von der in Verfahrensschritt S21 zum Näherungswert des Amplitudenminimums ermittelten Phase des ersten Hochfrequenzsignals $HF_1$ in Relation zur Phase des zweiten Hochfrequenzsignals $HF_2$ wird diese im nächsten Verfahrensschritt S22 bis zu einer ersten Phase $\varphi_1$ reduziert, bei der für die Amplitude $\overline{gsi}_{Out}$ des Messsignals $HF_{Out}$ ein vorher festgelegter Wert - in Fig. 6A und 6B der Wert C=-30 dB - gemessen wird.

Analog wird im darauffolgenden Verfahrensschritt S23 ausgehend von der in Verfahrensschritt S21 zum Näherungswert des Amplitudenminimums ermittelten Phase des ersten Hochfrequenzsignals $HF_1$ in Relation zur Phase des zweiten Hochfrequenzsignals $HF_2$ diese Phase des ersten Hochfrequenzsignals $HF_1$ in Relation zur Phase des zweiten Hochfrequenzsignals $HF_2$ bis zu einer zweiten Phase $\varphi_2$ erhöht, bei der für die Amplitude $\overline{gsi}_{Out}$ des Messsignals $HF_{Out}$ wiederum der vorher festgelegte Wert - in Fig. 6A und 6B der Wert C=-30 dB - gemessen wird.

In Verfahrensschritt S24 wird der exakte Wert für die Phase des ersten Hochfrequenzsignals $HF_1$ in Relation zur Phase des zweiten Hochfrequenzsignals $HF_2$ beim exakten Minimum der Amplitude $\overline{gsi}_{Out}$ des Messsignals $HF_{Out}$ als Mittelwert der ersten Phase $\varphi_1$ und der zweiten Phase $\varphi_2$ berechnet.

Der auf den Verfahrensschritt S20 folgende Verfahrenschritt S30 beinhaltet die sukzessive Variation der Amplitude $A$ des ersten Hochfrequenzsignals $HF_1$ in Relation zur Amplitude $B$ des zweiten Hochfrequenzsignals $HF_2$, um eventuell - im Fall des Vorliegens unterschiedlicher Amplituden $A$ und $B$ des ersten Hochfrequenzsignals $HF_1$ und des zweiten Hochfrequenzsignals $HF_2$ - ein neues Minimum der Amplitude $HF_{Out}$ des Messsignals $HF_{Out}$ zu ermitteln, das gegenüber dem durch Variation der Phase gewonnenen Amplitudenminimum des Messsignals $HF_{Out}$ minimiert ist.

Die Variation der Amplitude $A$ des ersten Hochfrequenzsignals $HF_1$ in Relation zur Amplitude B des zweiten Hochfrequenzsignals $HF_2$ erfolgt durch Verstellen des Verstärkungsfaktors des im Signalpfad des ersten Hochfrequenzsignals $HF_1$ befindlichen Leistungsverstärkers $5_1$ in Relation zum Verstärkungsfaktor des im Signalpfad des zweiten Hochfrequenzsignals $HF_2$ befindlichen Leistungsverstärkers $5_2$ oder durch Zuschalten von Widerstandselementen im elektronisch schaltbaren Dämpfungsglied $6_1$ des Signalpfads des ersten Hochfrequenzsignals $HF_1$ in Relation zum Zuschalten von Widerstandselementen im elektronisch schaltbaren Dämpfungsglied $6_2$ im Signalpfad des zweiten Hochfrequenzsignals $HF_2$.

Im darauffolgenden Verfahrensschritt S40 wird festgestellt, ob die für die Wiederherstellung der quantisierbaren Phasenkohärenz zwischen den beiden Hochfrequenzsignalen $HF_1$ und $HF_2$ erforderliche Phasengenauigkeit durch die in den vorherigen Verfahrensschritten ermittelte Phase des ersten Hochfrequenzsignals $HF_1$ in Relation zur Phase des zweiten Hochfrequenzsignals $HF_2$ erreicht ist. Genügt die Genauigkeit der ermittelten Phase des ersten Hochfrequenzsignals $HF_1$ in Relation zur Phase des zweiten Hochfrequenzsignals $HF_2$ den Anforderungen nicht, so wird wiederholt in Verfahrensschritt S20 die Phase des ersten Hochfrequenzsignals $HF_1$ in Relation zur Phase des zweiten Hochfrequenzsignals $HF_2$ geringfügig variiert, um ein Ergebnis mit erhöhter Genauigkeit zu erzielen. Andernfalls liegt das gewünschte Ergebnis vor und das Verfahren ist beendet.

**Patentansprüche**

1. Verfahren zur Herstellung einer quantisierbaren Phasenkohärenz zwischen einem ersten und zweiten Hochfrequenzsignal ($HF_1$, $HF_2$) mit folgenden Verfahrensschritten:

   • additives Verknüpfen des ersten und zweiten Hochfrequenzsignals ($HF_1$, $HF_2$) zu einem Messsignal ($HF_{Out}$) und Messen der Amplitude ($\overline{gsi}_{Out}$) des Messsignals ($HF_{Out}$) mit einem Spektrumanalysator (14),
   • sukzessives Variieren der Phase des ersten Hochfrequenzsignals ($HF_1$) relativ zur Phase des zweiten Hochfrequenzsignals $(HF_2)$, bis die Amplitude ($\overline{gsi}_{Out}$) des Messsignals $(HF_{Out})$ einen minimalen Wert aufweist, **dadurch gekennzeichnet,**

   **dass** die zum Minimum der Amplitude ($\overline{gsi}_{Out}$) des Messsignals ($HF_{Out}$) gehörige Phase des ersten Hochfrequenzsignals ($\underline{HF_1}$) relativ zur Phase des zweiten Hochfrequenzsignals $(HF_2)$ als Mittelwert einer bei einem frei wählbaren Amplitudenwert ($C$) des Messsignals ($\overline{gsi}_{Out}$) ermittelten ersten Phase ($\varphi_1$) des ersten Hoch-

frequenzsignals ($HF_1$), die gegenüber einer bei einem Näherungswert für das Minimum der Amplitude ($HF_{Out}^{gsi}$) des Messsignals ($HF_{Out}$) ermittelten Phase reduziert ist, und einer beim frei wählbaren Amplitudenwert ($C$) des Messsignals ($HF_{Out}$) ermittelten zweiten Phase ($\varphi_2$) des ersten Hochfrequenzsignals (HF) relativ zur Phase des zweiten Hochfrequenzsignals ($\overline{HF_2}$) die gegenüber einer beim Näherungswert für das Minimum der Amplitude ($HF_{Out}^{gsi}$) des Messsignals ($HF_{Out}$) ermittelten Phase erhöht ist, ermittelt wird.

2. Verfahren nach Anspruch 1,
   **dadurch gekennzeichnet,**
   **dass** das additive Verknüpfen des ersten und zweiten Hochfrequenzsignals ($HF_1$, $HF_2$) zu einem Messsignal ($HF_{Out}$) ein Summieren oder ein Subtrahieren des ersten und zweiten Hochfrequenzsignals ($HF_1$, $HF_2$) beinhaltet.

3. Verfahren nach Anspruch 1 oder 2,
   **dadurch gekennzeichnet,**
   **dass** im Wechsel zum sukzessiven Variieren der Phase des ersten Hochfrequenzsignals ($HF_1$) relativ zur Phase des zweiten Hochfrequenzsignals ($HF_2$) ein sukzessives Variieren der Amplitude ($A$) des ersten Hochfrequenzsignals ($HF_1$) zur Amplitude ($B$) des zweiten Hochfrequenzsignals ($HF_2$) erfolgt, bis die Amplitude ($HF_{Out}$) des Messsignals ($HF_{Out}$) einen minimalen Wert aufweist.

4. Verfahren nach einem der Ansprüche 1 bis 3,
   **dadurch gekennzeichnet,**
   **dass** zur Ermittlung der zum Minimum der Amplitude ($HF_{Out}$) des Messsignals ($HF_{Out}$) gehörigen Phase des ersten Hochfrequenzsignals ($HF_1$) relativ zur Phase des zweiten Hochfrequenzsignals ($HF_2$) folgende Verfahrensschritte durchgeführt werden:

   • Ermitteln eines Näherungswerts für die zum Minimum der Amplitude ($HF_{Out}$) des Messsignals ($HF_{Out}$) gehörige Phase des ersten Hochfrequenzsignals ($HF_1$) relativ zur Phase des zweiten Hochfrequenzsignals ($HF_2$),
   • Ermitteln einer ersten Phase ($\varphi_1$) durch Reduzieren der Phase des ersten Hochfrequenzsignals ($HF_1$) relativ zur Phase des zweiten Hochfrequenzsignals ($HF_2$) vom ermittelten Näherungswert der Phase des ersten Hochfrequenzsignals ($HF_1$) relativ zur Phase des zweiten Hochfrequenzsignals ($HF_2$), bis ein frei wählbarer Amplitudenwert ($C$) des Messsignals ($HF_{Out}$) erreicht ist,
   • Ermitteln einer zweiten Phase ($\varphi_2$) durch Erhöhen der Phase des ersten Hochfrequenzsignals ($HF_1$) relativ zur Phase des zweiten Hochfrequenzsignals ($HF_2$) vom ermittelten Näherungswert der Phase des ersten Hochfrequenzsignals ($HF_1$) relativ zur Phase des zweiten Hochfrequenzsignals ($HF_2$), bis der frei wählbare Amplitudenwert ($C$) des Messsignals ($HF_{Out}$) erreicht ist, und
   • Ermitteln eines exakten Werts der Phase des ersten Hochfrequenzsignals ($HF_1$) relativ zur Phase des zweiten Hochfrequenzsignals ($HF_2$) als Mittelwert der ermittelten ersten und zweiten Phase ($\varphi_1$, $\varphi_2$) des ersten Hochfrequenzsignals.

5. Verfahren nach einem der Ansprüche 1 bis 4,
   **dadurch gekennzeichnet,**
   **dass** das sukzessive Variieren der Phase des ersten Hochfrequenzsignals ($HF_1$,) zur Phase des zweiten Hochfrequenzsignals ($HF_2$) in einem Signalgenerator (10) durch Verstellen der Phase des zum ersten Hochfrequenzsignal ($HF_1$) gehörigen ersten Trägersignals ($TR_1$) in Relation zur Phase des zum zweiten Hochfrequenzsignal ($HF_2$) gehörigen zweiten Trägersignals ($TR_2$) oder durch Verstellen der Phase des zum ersten Hochfrequenzsignal ($HF_1$) gehörigen ersten Basisbandsignals ($BB_1$) in Relation zur Phase des zum zweiten Hochfrequenzsignal ($HF_2$) gehörigen zweiten Basisbandsignals ($BB_2$) erfolgt.

6. Verfahren nach einem der Ansprüche 1 bis 5,
   **dadurch gekennzeichnet,**
   **dass** das sukzessive Variieren der Amplitude ($A$) des ersten Hochfrequenzsignals ($HF_1$) zur Amplitude ($B$) des zweiten Hochfrequenzsignals ($HF_2$) in einem Signalgenerator (10) durch Verstellen des Verstärkungsfaktors von in einem Signalpfad des ersten Hochfrequenzsignals ($HF_1$) befindlichen Verstärkern ($5_1$, $6_1$) in Relation zum Verstärkungsfaktor von in einem Signalpfad des zweiten Hochfrequenzsignals ($HF_2$) befindlichen Verstärkern ($5_2$, $6_2$) erfolgt.

7. Verfahren nach Anspruch 5 oder 6,
**dadurch gekennzeichnet,**
**dass** das automatisierte Verstellen der Phase des ersten bzw. zweiten Basisbandsignals *(BB$_1$, BB$_2$),* der Phase des ersten bzw. zweiten Trägersignals *(TR$_1$,TR$_2$)* und/oder des Verstärkungsfaktors der im Signalpfad des ersten bzw. zweiten Hochfrequenzsignals *(HF$_1$, HF$_2$)* befindlichen Verstärker (5$_1$,6$_1$,5$_2$,6$_2$) einmalig, kontinuierlich in einem bestimmten Zeitraster innerhalb eines bestimmten Zeitintervalls und/oder in einem bestimmten Frequenzraster innerhalb eines bestimmten Frequenzspektrums erfolgt.

8. Verfahren nach einem der Ansprüche 5 bis 7,
**dadurch gekennzeichnet,**
**dass** das erste und zweite Hochfrequenzsignal *(HF$_1$, HF$_2$)* jeweils eine konstante Amplitude und Frequenz aufweist und das erste und zweite Basisbandsignal *(BB$_1$,BB$_2$)* jeweils ein Gleichspannungssignal ist.

9. Verfahren nach einem der Ansprüche 1 bis 8,
**dadurch gekennzeichnet,**
**dass** die Amplitude des Messsignals *(HF$_{Out}$)* zur Unterdrückung eines überlagerten Rauschanteils gemittelt wird.

10. Verfahren nach Anspruch 5,
**dadurch gekennzeichnet,**
**dass** für das erste und zweite Basisbandsignal *(BB$_1$, BB$_2$)* im zeitlichen Wechsel mehrere unterschiedliche Symbole des in einem Modulator des Signalgenerators (10) benutzten Symbolalphabets zum zeitlichen Ausmitteln einer Phasendrift der Phase des ersten und/oder zweiten Basisbandsignals *(BB$_1$,BB$_2$)* aufgrund von unterschiedlichen Pegelverstärkungen zwischen Inphase- und Quadraturkanal verwendet werden.

11. Vorrichtung zur Herstellung einer quantisierbaren Phasenkohärenz zwischen einem ersten und zweiten Hochfrequenzsignal *(HF$_1$, HF$_2$)* eingerichtet zur Durchführung des Verfahrens nach einem der Ansprüche 1 bis 10, mit einem ein erstes und zweites Hochfrequenzsignal *(HF$_1$,HF$_2$)* erzeugenden Signalgenerator (10), einer das erste und zweite Hochfrequenzsignal *(HF$_1$, HF$_2$)* additiv zu einem Messsignal *(HF$_{Out}$)* verknüpfenden Signalverknüpfungseinheit (13) und einem das Messsignal *(HF$_{Out}$)* messenden Spektrumanalysator (14).

12. Vorrichtung nach Anspruch 11,
**dadurch gekennzeichnet,**
**dass** die Signalverknüpfungseinheit (13) ein Addierer oder Subtrahierer ist.

13. Vorrichtung nach Anspruch 12,
**dadurch gekennzeichnet,**
**dass** der Addier ein in umgekehrter Signalpfadrichtung geschalteter ohmscher Leistungsteiler ist.

**Claims**

1. A method for manufacturing a quantisable phase coherence between a first and second high-frequency signal *(HF$_1$, HF$_2$)* with the following method steps:

    - additive linking of the first and second high-frequency signal *(HF$_1$,HF$_2$)* to form a measured signal *(HF$_{Out}$)* and measurement of the amplitude *(HF$_{Out}$)* of the measured signal *(HF$_{Out}$)* with a spectrum analyser (14),
    - successive variation of the phase of the first high-frequency signal *(HF$_1$)* relative to the phase of the second high-frequency signal (HF$_2$) until the amplitude *(HF$_{Out}$)* of the measured signal *(HF$_{Out}$)* provides a minimal value,
    **characterised in that**

    the phase of the first high-frequency signal (H*F$_1$)* associated with the minimum of the amplitude (*$_{Out}$*) of the measured signal *(HF$_{Out}$)* relative to the phase of the second high-frequency signal (HF$_2$) is determined as a mean value of a first phase (φ$_1$) of the first high-frequency signal *(HF$_1$)* determined at a freely selectable amplitude value (C), which is reduced by comparison with a phase determined at an approximate value for the minimum of the amplitude (*$_{Out}$*) of the measured signal *(HF$_{Out}$),* and a second phase (φ$_2$) of the first high-

frequency signal $(HF_1)$ determined at the freely selectable amplitude value (C) of the measured signal $(HF_{Out})$ relative to the phase of the second high-frequency signal $(HF_2)$, which is increased by comparison with a phase determined at an approximate value for the minimum of the amplitude $(\widetilde{HF}_{Out})$ of the measured signal $(HF_{Out})$.

2. The method according to claim 1,
   **characterised in that**
   the additive linking of the first and second high-frequency signal $(HF_1, HF_2)$ to form a measured signal $(HF_{Out})$ contains a summation or a subtraction of the first and second high-frequency signal $(HF_1, HF_2)$ .

3. The method according to claim 1 or 2,
   **characterised in that**,
   in alternation with the successive variation of the phase of the first high-frequency signal $(HF_1)$ relative to the phase of the second high-frequency signal $(HF_2)$, a successive variation of the amplitude (A) of the first high-frequency signal $(HF_1)$ relative to the amplitude (B) of the second high-frequency signal $(HF_2)$ is implemented until the amplitude $(HF_{Out})$ of the measured signal $(HF_{Out})$ provides a minimum value.

4. The method according to any one of claims 1 to 3,
   **characterised in that**,
   for the determination of the phase of the first high-frequency signal $(HF_1)$ associated with the minimum of the amplitude $(HF_{Out})$ of the measured signal $(HF_{Out})$ relative to the phase of the second high-frequency signal $(HF_2)$, the following method steps are implemented:

   - determination of an approximate value for the phase of the first high-frequency signal $(HF_1)$ associated with the minimum of the amplitude $(\widetilde{HF}_{Out})$ of the measured signal $(HF_{Out})$ relative to the phase of the second high-frequency signal $(HF_2)$,
   - determination of a first phase $(\varphi_1)$ by reducing the phase of the first high-frequency signal $(HF_1)$ relative to the phase of the second high-frequency signal $(HF_2)$ from the determined approximate value of the phase of the first high-frequency signal $(HF_1)$ relative to the phase of the second high-frequency signal $(HF_2)$ until a freely selectable amplitude value (C) of the measured signal $(HF_{Out})$ is reached,
   - determination of a second phase $(\varphi_2)$ by increasing the phase of the first high-frequency signal $(HF_1)$ relative to the phase of the second high-frequency signal $(HF_2)$ from the determined approximate value of the phase of the first high-frequency signal $(HF_1)$ relative to the phase of the second high-frequency signal $(HF_2)$ until the freely selectable amplitude value (C) of the measured signal $(HF_{Out})$ is reached, and
   - determination of an exact value of the phase of the first high-frequency signal $(HF_1)$ relative to the phase of the second high-frequency signal $(HF_2)$ as a mean value of the determined first and second phase $(\varphi_1, \varphi_2)$ of the first high-frequency signal.

5. The method according to any one of claims 1 to 4,
   **characterised in that**
   the successive variation of the phase of the first high-frequency signal $(HF_1)$ relative to the phase of the second high-frequency signal $(HF_2)$ is implemented in a signal generator (10) by adjusting the phase of the first carrier signal $(TR_1)$ associated with the first high-frequency signal $(HF_1)$ in relation to the phase of the second carrier signal $(TR_2)$ associated with the second high-frequency signal $(HF_2)$ or by adjusting the phase of the first baseband signal $(BB_1)$ associated with the first high-frequency signal $(HF_1)$ in relation to the phase of the second baseband signal $(BB_2)$ associated with the second high-frequency signal $(HF_2)$.

6. The method according to any one of claims 1 to 5,
   **characterised in that**
   the successive variation of the amplitude (A) of the first high-frequency signal $(HF_1)$ to the amplitude (B) of the second high-frequency signal $(HF_2)$ is implemented in a signal generator (10) by adjusting the amplification factor of amplifiers $(5_1, 6_1)$ disposed in a signal path of the first high-frequency signal $(HF_1)$ in relation to the amplification factor of amplifiers $(5_2, 6_2)$ disposed in a signal path of the second high-frequency signal $(HF_2)$.

7. The method according to claim 5 or 6,
   **characterised in that**

the automated adjustment of the phase of the first or respectively second baseband signal *(BB$_1$,BB$_2$)*, of the phase of the first or respectively second carrier signal *(TR$_1$,TR$_2$)* and/or of the amplification factor of the amplifiers (5$_1$, 6$_1$, 5$_2$, 6$_2$) disposed in the signal path of the first or respectively second high-frequency signal *(HF$_1$,HF$_2$)* is implemented uniquely, continuously in a given time raster within a given time interval and/or in a given frequency raster within a given frequency spectrum.

8. The method according to any one of claims 5 to 7,
   **characterised in that**
   the first and second high-frequency signal (*HF$_1$,HF$_2$*) in each case provides a constant amplitude and frequency, and the first and second baseband signal (*BB$_1$,BB$_2$*) in each case is a DC signal.

9. The method according to any one of claims 1 to 8,
   **characterised in that**
   the amplitude of the measured signal (*HF$_{Out}$*) is averaged for the suppression of a superimposed noise component.

10. The method according to claim 5,
    **characterised in that**,
    for the first and second baseband signal (*BB$_1$,BB$_2$*) in time alternation, several different symbols of the symbol alphabet used in a modulator of the signal generator (10) are used for the time averaging of a phase drift of the phase of the first and/or second baseband signal (*BB$_1$,BB$_2$*) on the basis of different level amplifications between inphase and quadrature channel.

11. A device for manufacturing a quantisable phase coherence between a first and second high-frequency signal (*HF*, *HF$_2$*) set up for the implementation of the method according to any one of claims 1 to 10, with
    a signal generator (10) generating a first and second high-frequency signal (*HF$_1$,HF$_2$*),
    a signal-linking unit (13) linking the first and second high-frequency signal (*HF$_1$,HF$_2$*) in an additive manner to a measured signal (*HF$_{Out}$*), and a spectrum analyser (14) measuring the measured signal (*HF$_{Out}$*).

12. The device according to claim 11,
    **characterised in that**
    the signal linking unit (13) is an adder or a subtractor.

13. The device according to claim 12,
    **characterised in that**
    the adder is an ohmic power splitter connected in reverse signal-path direction.

## Revendications

1. Procédé pour produire une cohérence de phase quantifiable entre un premier et un second signal haute fréquence (HF$_1$, HF$_2$) comportant les étapes de procédé suivantes :

   - combinaison additive du premier et du second signal haute fréquence (HF$_1$, HF$_2$) en un signal de mesure (HF$_{Out}$) et mesure de l'amplitude ($\overline{gsi}_{Out}$) du signal de mesure (HF$_{Out}$) avec un analyseur de spectre (14),
   - variation successive de la phase du premier signal haute fréquence (HF$_1$) par rapport à la phase du second signal haute fréquence (HF$_2$), jusqu'à ce que l'amplitude ($\overline{gsi}_{Out}$) du signal de mesure (HF$_{Out}$) présente une valeur minimale,
   **caractérisé en ce que**
   la phase associée au minimum de l'amplitude ($\overline{gsi}_{Out}$) du signal de mesure (HF$_{Out}$) du premier signal haute fréquence (HF$_1$) par rapport à la phase du second signal haute fréquence (HF$_2$) est déterminée en tant que valeur moyenne d'une première phase ($\varphi_1$) déterminée pour une valeur d'amplitude (C) pouvant être choisie librement du signal de mesure (HF$_{Out}$) du premier signal haute fréquence (HF$_1$), qui est réduite par rapport à une phase déterminée pour une valeur approchée pour le minimum de l'amplitude ($\mathtt{gsi}_{Out}$) du signal de mesure (HF$_{Out}$), et d'une seconde phase ($\varphi_2$) déterminée pour la valeur d'amplitude pouvant être librement choisie (C) du signal de mesure (HF$_{Out}$) du premier signal haute fréquence (HF$_1$) par rapport à la phase du second signal haute fréquence (HF$_2$), qui est augmentée par rapport à la phase déterminée pour la valeur approchée pour le minimum de l'amplitude ($\mathtt{gsi}_{Out}$) du signal de mesure (HF$_{Out}$) .

2. Procédé selon la revendication 1, **caractérisé en ce que**
le couplage additif du premier et du second signal haute fréquence (HF$_1$, HF$_2$) en un signal de mesure (HF$_{Out}$) comporte l'addition ou la soustraction du premier et du second signal haute fréquence (HF$_1$, HF$_2$).

3. Procédé selon la revendication 1 ou 2, **caractérisé en ce que**
en variante à la variation successive de la phase du premier signal haute fréquence (HF$_1$) par rapport à la phase du second signal haute fréquence (HF$_2$) se produit une variation successive de l'amplitude (A) du premier signal haute fréquence (HF$_1$) par rapport à l'amplitude (B) du second signal haute fréquence (HF$_2$) , jusqu'à ce que l'amplitude ($\mathtt{gsi}_{Out}$) du signal de mesure (HF$_{Out}$) présente une valeur minimale.

4. Procédé selon l'une des revendications 1 à 3, **caractérisé en ce que**
en vue de la détermination de la phase associée
au minimum de l'amplitude ($\mathtt{gsi}_{out}$) du signal de mesure (HF$_{Out}$) du premier signal haute fréquence (HF$_1$) par rapport à la phase du second signal haute fréquence (HF$_2$), les étapes de procédé suivantes sont effectuées :

- détermination d'une valeur approchée pour la

phase associée au minimum de l'amplitude (($\mathtt{gsi}_{out}$) du signal de mesure (HF$_{Out}$) du premier signal haute fréquence (HF$_1$) par rapport à la phase du second signal haute fréquence (HF$_2$),

- détermination d'une première phase ($\varphi_1$) en réduisant la phase du premier signal haute fréquence (HF$_1$) par rapport à la phase du second signal haute fréquence (HF$_2$) par la valeur approchée déterminée de la phase du premier signal haute fréquence (HF$_1$) par rapport à la phase du second signal haute fréquence (HF$_2$), jusqu'à ce qu'une valeur d'amplitude pouvant être choisie librement (C) du signal de mesure (HF$_{Out}$) soit atteinte,
- détermination d'une seconde phase ($\varphi_2$) par augmentation de la phase du premier signal haute fréquence (HF$_1$) par rapport à la phase du second signal haute fréquence (HF$_2$) par la valeur approchée déterminée de la phase du premier signal haute fréquence (HF$_1$) par rapport à la phase du second signal haute fréquence (HF$_2$), jusqu'à ce que la valeur d'amplitude pouvant être choisie librement (C) du signal de mesure (HF$_{Out}$) soit atteinte, et
- détermination d'une valeur exacte de la phase du premier signal haute fréquence (HF$_1$) par rapport à la phase du second signal haute fréquence (HF$_2$) en tant que valeur moyenne de la première et de la seconde phase déterminée ($\varphi_1$, $\varphi_2$) du premier signal haute fréquence.

5. Procédé selon l'une des revendications 1 à 4, **caractérisé en ce que**
la variation successive de la phase du premier signal haute fréquence (HF$_1$) par rapport à la phase du second signal haute fréquence (HF$_2$) se produit dans un générateur de signal (10) par réglage de la phase du premier signal de porteuse (TR$_1$) associé au premier signal haute fréquence (HF$_1$) en relation avec la phase du second signal de porteuse (TR$_2$) associé au second signal haute fréquence (HF$_2$) ou par réglage de la phase du premier signal en bande de base (BB$_1$) associé au premier signal haute fréquence (HF$_1$) en relation avec la phase du second signal en bande de base (BB$_2$) associé au second signal haute fréquence (HF$_2$).

6. Procédé selon l'une des revendications 1 à 5, **caractérisé en ce que**
la variation successive de l'amplitude (A) du premier signal haute fréquence (HF$_1$) par rapport à l'amplitude (B) du second signal haute fréquence (HF$_2$) se produit dans un générateur de signal (10) par réglage du facteur d'amplification d'amplificateurs (5$_1$, 6$_1$) se trouvant dans le trajet de signal du premier signal haute fréquence (HF$_1$) en relation avec le facteur d'amplification d'amplificateurs (5$_2$, 6$_2$) se trouvant dans un trajet de signal du second signal

haute fréquence (HF$_2$).

7. Procédé selon la revendication 5 ou 6, **caractérisé en ce que**
le réglage automatique de la phase du premier ou du second signal en bande de base (BB$_1$, BB$_2$), de la phase du premier ou du second signal de porteuse (TR$_1$, TR$_2$) et/ou du facteur d'amplification des amplificateurs (5$_1$, 6$_1$, 5$_2$, 6$_2$) se trouvant dans un trajet de signal du premier ou du second signal haute fréquence (HF$_1$, HF$_2$) se produit une seule fois de façon continue dans une période de temps déterminée à l'intérieur d'un intervalle de temps déterminé et/ou dans une période de fréquence déterminée à l'intérieur d'un spectre de fréquence déterminé.

8. Procédé selon l'une des revendications 5 à 7, **caractérisé en ce que**
le premier et le second signal haute fréquence (HF$_1$, HF$_2$) présentent respectivement une amplitude et une fréquence constantes et le premier et le second signal en bande de base (BB$_1$, BB$_2$) est respectivement un signal de tension continue.

9. Procédé selon l'une des revendications 1 à 8, **caractérisé en ce que**
l'amplitude du signal de mesure (HF$_{Out}$) est moyennée en vue de la suppression d'une composante de bruit superposée.

10. Procédé selon la revendication 5, **caractérisé en ce que**
pour le premier et le second signal en bande de base (BB$_1$, BB$_2$) en alternance, plusieurs signaux différents de l'alphabet de symboles utilisé dans un modulateur du générateur de signal (10) sont utilisés pour homogénéiser temporellement une dérive de phase de la phase du premier et/ou du second signal en bande de base (BB$_1$, BB$_2$) en raison des différentes amplifications de niveau entre le canal en phase et en quadrature.

11. Dispositif pour produire une cohérence de phase quantifiable entre un premier et un second signal haute fréquence (HF$_1$, HF$_2$) agencé en vue de l'exécution du procédé selon l'une des revendications 1 à 10, grâce à
un générateur de signal (10) produisant un premier et un second signal haute fréquence (HF$_1$, HF$_2$),
une unité de combinaison de signal (13) combinant de plus le premier et le second signal haute fréquence (HF$_1$, HF$_2$) à un signal de mesure (HF$_{Out}$) et
un analyseur de spectre (14) mesurant le signal de mesure (fout).

12. Dispositif selon la revendication 11, **caractérisé en ce que**
l'unité de combinaison de signal (13) est un additionneur ou un soustracteur.

13. Dispositif selon la revendication 12, **caractérisé en ce que**
L'additionneur est un diviseur de puissance ohmique commuté dans une direction inversée du trajet de signal.

Fig. 1

Fig. 2

Fig. 3

Fig. 4A

Fig. 4B

Fig. 5

Fig. 6A

Fig. 6B

Fig. 7

Start

Verknüpfen der beiden Hochfrequenzsignale $HF_1$ und $HF_2$ über einen Addierer oder Subtrahierer und Messen der Amplitude des vom Addierer oder Subtrahierers gelieferten Messsignals $HF_{out}$ ——S10

Bestimmen des Amplitudenminimums durch Variieren der Phase des ersten HF-Signals $HF_1$ in Relation zur Phase des zweiten HF-Signals $HF_2$ ——S20

Optimiertes Bestimmen des Amplitudenminimums durch Variieren der Amplitude A des ersten HF-Signals $HF_1$ in Relation zur Amplitude B des zweiten HF-Signals $HF_2$ ——S30

S40

nein ——— Messge-nauigkeit erreicht ? ——— ja

Ende

Fig. 8A

Start

Ermitteln eines Näherungswert des Amplitudenminimums durch Variieren der Phase des ersten HF-Signals $HF_1$ zur Phase des zweiten HF-Signals $HF_2$ ——S21

Reduzieren der Phase des ersten HF-Signals $HF_1$ zur Phase des zweiten HF-Signals $HF_2$ ausgehend von der zum Näherungswert des Amplitudenminimums gehörigen Phase, bis erste Phase erreicht ist, bei der ein vorher festgelegter Amplitudenwert gemessen wird ——S22

Erhöhen der Phase des ersten HF-Signals $HF_1$ zur Phase des zweiten HF-Signals $HF_2$ ausgehend von der zum Näherungswert des Amplitudenminimums gehörigen Phase, bis zweite Phase erreicht ist, bei der derselbe vorher festgelegte Amplitudenwert gemessen wird ——S23

Ermitteln eines exakten Werts für die Phase beim exakten Amplitudenminimum durch Mitteln der ersten und zweiten Phase ——S24

Ende

## Fig. 8B

**EP 2 149 996 B1**

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 10130687 A1

- WO 403093841 A